# EUROPÄISCHE PATENTANMELDUNG

(11) **EP 0 975 087 A1**
(43) Veröffentlichungstag der Anmeldung: **26.01.2000**
(21) Anmeldenummer: 99202302.8
(22) Anmeldetag: 13.07.1999
(51) Int. Cl.: H03B 5/12, H03K 3/283, H03K 3/354

(54) **Oszillatorschaltung**

(30) Priorität: 23.07.1998 DE 19833072
(71) Anmelder: Philips Corporate Intellectual Property GmbH, 52064 Aachen (DE); Koninklijke Philips Electronics N.V., 5621 BA Eindhoven (NL)
(72) Erfinder: Wichern, Andreas, Röntgenstrasse 24, 22335 Hamburg (DE)
(74) Vertreter: Peters, Carl Heinrich, Dipl.-Ing.

(57) **Zusammenfassung**

Beschrieben wird eine Oszillatorschaltung mit einem Resonanzkreis mit zwei Polen, über denen eine in der Oszillatorschaltung erzeugte Schwingung greifbar ist und mit einem Differenzverstärker aus zwei emittergekoppelten Transistoren mit zwei Kollektoranschlüssen, von denen je einer mit je einem der Pole des Resonanzkreises verbunden ist, und mit zwei Basisanschlüssen, die über Kreuz mit den Polen des Resonanzkreises gekoppelt sind.

Eine derartige Oszillatorschaltung kann dadurch mit geringem Schaltungsaufwand in der Weise ausgebildet werden, daß die erzeugte Schwingung störungsarm ist, daß die Kopplung der Basisanschlüsse mit den Polen des Resonanzkreises über je eine Diodenanordnung vorgenommen ist.

## Beschreibung

Die Erfindung bezieht sich auf eine Oszillatorschaltung mit einem Resonanzkreis mit zwei Polen, über denen eine in der Oszillatorschaltung erzeugte Schwingung greifbar ist und mit einem Differenzverstärker aus zwei emittergekoppelten Transistoren mit zwei Kollektoranschlüssen, von denen je einer mit je einem der Pole des Resonanzkreises verbunden ist, und mit zwei Basisanschlüssen, die über Kreuz mit den Polen des Resonanzkreises gekoppelt sind.

In der Schaltungstechnik für die Verarbeitung hochfrequenter elektromagnetischer Schwingungen werden häufig, insbesondere in Phasenregelschleifen, spannungsgesteuerte Oszillatoren eingesetzt. Für die Integration derartiger Oszillatoren auf einem Halbleiterkörper werden Schaltungen bevorzugt, die im Gegentakt bzw. differentiell arbeiten, um die Stromflußschleife bezüglich des frequenzbestimmenden Resonanzkreises möglichst klein zu halten, da in dieser Stromflußschleife extrem hohe Blindstörme fließen. Dies gilt unabhängig davon, ob die Stromflußschleife innerhalb des Halbleiterkörpers verläuft oder ob Teile des Resonanzkreises außerhalb des Halbleiterkörpers angeordnet werden. Eine möglichst kleine Stromflußschleife, d.h. eine möglichst kompakt aufgebaute Leiteranordnung, in der die genannten Blindströme eine möglichst geringe Fläche umschließen, vermindert außerdem die Abstrahlung von Hochfrequenzenergie und verringert umgekehrt die Anfälligkeit der Oszillatorschaltung für Störungen von außen. Derartige elektromagnetische Störungen treten in erster Linie durch Einstreuungen über elektromagnetische Felder oder auch über die Versorgungsleitungen auf und machen sich als Gleichtaktaussteuerung bemerkbar. Mit dem genannten Aufbau der Oszillatorschaltung wird außerdem ein guter Wert für den Phasenrauschabstand erzielt, da sich die Signalamplituden an den Elementen des Differenzverstärkers arithmetisch addieren, wohingegen das Rauschen sich quadratisch summiert.

In einer einfachen Ausbildung umfaßt die Oszillatorschaltung der eingangs genannten Art im wesentlichen einen emittergekoppelten Differenzverstärker, dessen Basis- und Kollektoranschlüsse kreuzweise rückgekoppelt sind. Dabei sind die Kollektoranschlüsse miteinander über den Resonanzkreis verbunden, wohingegen die Basisanschlüsse mit den Kollektoranschlüssen des jeweils anderen Verstärkungselementes des Differenzverstärkers verbunden sind. Durch diese kreuzweise Rückführung entsteht eine Mitkopplung, die den Resonanzkreis so weit entdämpft, daß Schwingungen entstehen. Dabei leitet wechselweise jeweils eines der Elemente des Differenzverstärkers. Durch entsprechend starke Schwingungsanfachung kann die Amplitude der elektrischen Spannung an den Elementen des Differenzverstärkers so groß werden, daß diese in die Sättigung geraten. Beim Eintritt in die Sättigung wird jedoch die Schwingungsamplitude über dem Resonanzkreis abrupt begrenzt. Dies führt zu einem hohen Oberwellengehalt der von der Oszillatorschaltung abgegebenen Schwingung. Außerdem können durch dabei auftretende Mischprozesse niederfrequente Rauschanteile auf die abgegebene Schwingung moduliert und damit der Phasenrauschabstand verschlechtert werden.

Aus der EP 0 746 092 A1 ist eine Ausbildung einer Oszillatorschaltung der eingangs genannten Art bekannt, mit der versucht werden kann, die vorstehenden Nachteile zu umgehen. Der in dieser Druckschrift beschriebene Oszillator umfaßt eine Differenzverstärkerstufe aus zwei Transistoren, die mit ihren Emitteranschlüssen gemeinsam über eine Stromquelle mit Masse verbunden sind. Die Kollektoranschlüsse der Transistoren sind über je einen Kollektorwiderstand mit einem Versorgungsspannungsanschluß verbunden. Jeder der Kollektoranschlüsse der Transistoren ist mit dem Basisanschluß eines Emitterfolgertransistors verbunden, deren Kollektoranschlüsse am Versorgungsspannungsanschluß liegen und deren Emitteranschlüsse mit Ausgangsanschlüssen verbunden sind zum Abgreifen der in der Oszillatorschaltung erzeugten Schwingung. Von jedem der Emitterfolgertransistoren ist über dessen Emitteranschluß eine Verbindung an den Basisanschluß eines der Transistoren der Differenzverstärkerstufe hergestellt in der Weise, daß über jeden der Emitterfolgertransistoren der Kollektoranschluß eines der Transistoren mit dem Basisanschluß des jeweils anderen Transistors der Differenzverstärkerstufe gekoppelt ist. Auf diese Weise wird eine Mitkopplung erzielt. Die für die Schwingfrequenz maßgeblichen frequenzbestimmenden Elemente sind zwischen den Kollektoranschlüssen der Transistoren der Differenzverstärkerstufe angeschlossen. Zur Speisung der Emitterfolgertransistoren sind deren Emitteranschlüsse mit Stromquellen verbunden, die gegen Masse geschaltet sind.

Bei dieser aus der EP 0 746 092 A1 bekannten Oszillatorschaltung ist zwar das Kollektor-Basis-Potential der Transistoren der Differenzverstärkerstufe größer als bei der Oszillatorschaltung ohne die Emitterfolgertransistoren, und das Kollektorpotential der Emitterfolgertransistoren kann nicht niedriger werden als die Versorgungsspannung. Dennoch sorgt auch bei dieser Oszillatorschaltung die eintretende Sättigung des Emitterfolgertransistors bzw. des Transistors der Differenzverstärkerstufe, der jeweils in den leitenden Zustand gerät, für eine Begrenzung der Amplitude der erzeugten Schwingung, da nach wie vor das Basispotential sowohl der Transistoren der Differenzverstärkerstufe merkbar als auch dasjenige der Emitterfolgertransistoren weit über den Wert der Versorgungsspannung ansteigen kann. Außerdem ergeben sich durch die Verwendung der Emitterfolgertransistoren und deren Gleichstromspeisung weitere niederfrequente Rauschanteile, die eine weitere Modulation der erzeugten Schwingung bewirken und auf diese Weise den Phasenrauschabstand verschlechtern.

Die Erfindung hat die Aufgabe, eine Oszillatorschaltung der eingangs genannten Art mit geringem Schaltungsaufwand in der Weise auszubilden, daß die erzeugte Schwingung störungsarm ist.

Erfindungsgemäß wird diese Aufgabe bei einer Oszillatorschaltung der gattungsgemäßen Art dadurch gelöst, daß die Kopplung der Basisanschlüsse mit den Polen des Resonanzkreises über je eine Diodenanordnung vorgenommen sit.

Die erfindungsgemäß eingesetzten Diodenanordnungen haben den Vorteil, daß einerseits keine zusätzlichen Elemente, insbesondere Stromquellenschaltungen, zur Arbeitspunkteinstellung benötigt werden. Da derartige Elemente in der Regel zusätzliche Rauschquellen darstellen, kann das Rauschen bei der erfindungsgemäßen Oszillatorschaltung vermindert und somit insbesondere der Phasenrauschabstand vergrößert werden. Außerdem tritt bei der erfindungsgemäß eingesetzten Diodenanordnung der beschriebene Effekt der Sättigung nicht auf. Die dadurch hervorgerufenen Störungen durch Oberwellen, d.h. ein mit der Sättigung sich stark erhöhender Oberwellengehalt, werden dadurch vermieden. Vielmehr wird die Amplitude der erzeugten Schwingung ausschließlich durch das Nachlassen der Verstärkung und damit der Mitkopplung in der Oszillatorschaltung bei zunehmender Gegentaktaussteuerung (differentieller Aussteuerung) der emittergekoppelten Transistoren des Differenzverstärkers bestimmt, so daß als erzeugte Schwingung ein symmetrisches Sinussignal mit sehr geringem Oberwellenanteil auftritt. Durch die damit auch verringerten Mischprozesse wird ebenfalls das Phasenrauschen vermindert.

In einer vorteilhaften Ausgestaltung der erfindungsgemäßen Oszillatorschaltung umfassen die Diodenanordnungen je wenigstens einen Basis-Kollektor-gekoppelten Transistor. Ein auf diese Weise als Diode geschalteter Transistor stellt eine fertigungstechnisch sehr einfache und bezüglich ihrer Betriebsparameter sehr vorteilhafte Ausbildung für die von der erfindungsgemäßen Oszillatorschaltung umfaßten Diodenanordnungen dar. Bedarfsweise kann jede der Diodenanordnungen auch mehrere durch Basis-Kollekror-Kopplung als Dioden geschaltete Transistoren in Reihenschaltung umfassen. Dadurch kann die gewünsche Potentialdifferenz in den mit Kopplungszweigen des Differenzverstärkers, d.h. in den über Kreuz mit den Polen des Resonanzkreises gekoppelten Basisanschlüssen der emittergekoppelten Transistoren des Differenzverstärkers, gewählt werden.

Die Erfindung ist bevorzugt einsetzbar für die Ausgestaltung von Oszillatorschaltungen für phasenverriegelte Schleifen, vorzugsweise für die Erzeugung phasenstabiler Schwingungen mit geringem Klirrfaktor. Derartige Oszillatorschaltungen und damit ausgestattete phasenverriegelte Schleifen werden in allen Bereichen der elektrischen Nachrichtentechnik verwendet. Ein bevorzugtes Einsatzgebiet stellen Radio-, Audio- und/oder Fernsehsignal-Verarbeitungsschaltungen und die Geräte dar, in denen diese eingesetzt werden. Ein weiteres, bevorzugtes Anwendungsgebiet sind Navigationssysteme, beispielsweise GPS-Anlagen.

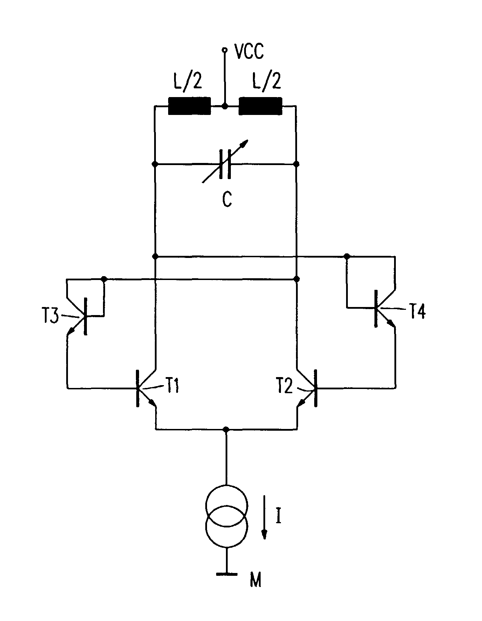

Ein Ausführungsbeispiel der Erfindung ist in der Zeichnung dargestellt und wird im nachfolgenden näher beschrieben.

Die in der einzigen Figur dargestellte, erfindungsgemäße Oszillatorschaltung umfaßt einen Differenzverstärker aus zwei emittergekoppelten Transistoren T1 und T2. Vom Kopplungspunkt der Emitteranschlüsse der Transistoren T1, T2 ist eine Gleichstromquelle, die einen Strom I führt, an Masse M gelegt. Die Kollektoranschlüsse der Transistoren T1 und T2 des Differenzverstärkers sind über je eine Teilinduktivität L/2 mir einem positiven Pol einer Versorgungsspannungsquelle verbunden, die eine gegenüber Masse M positive Versorgungsgleichspannung VCC führt. Die Verbindungspunkte zwischen den Teilinduktivitäten L/2 und den Kollektoranschlüssen der Transistoren T1, T2 bilden Pole eines Resonanzkreises, der außer den Teilinduktivitäten L/2 eine variable Kapazität C enthält, deren Anschlüsse mit je einem der Pole des Resonanzkreises verbunden sind. Im Resonanzkreis sind die Teilinduktivitäten L/2 in Reihe angeordnet und ergeben zusammen die Induktivität L des Resonanzkreises. Dieser Resonanzkreis bildet wechselstrommäßig einen Sperrkreis, über den die Kollektoranschlüsse der Transistoren T1, T2 des Differenzverstärkers gekoppelt sind.

Die Basisanschlüsse der Transistoren T1, T2 des Differenzverstärkers sind über Kreuz mit den Kollektoranschlüssen der Transistoren T1, T2, d.h. mit den Polen des Resonanzkreises, gekoppelt. Diese Kopplung erfolgt über als Dioden geschaltete Transistoren, bei denen Kollektor- und Basisanschluß miteinander verbunden sind. Ein erster Transistor T3 dieser als Diode geschalteten Transistoren verbindet den Basisanschluß des Transistors T1 des Differenzverstärkers mit dem Kollektoranschluß des Transistors T2. Ein zweiter Transistor T4 dieser als Diode geschalteten Transistoren verbindet entsprechend den Basisanschluß des Transistors T2 des Differenzverstärkers mit dem Kollektoranschluß des Transistors T1.

Wie bei einer einfachen Oszillatorschaltung, bei der anstelle der als Dioden geschalteten Transistoren T3, T4 einfache, galvanische Verbindungen vorgesehen sind, entsteht auch bei der in der Figur dargestellten Ausführungsform der Erfindung durch die kreuzweise Rückführung eine Mitkopplung, die den Resonanzkreis L bzw. L/2, C so weit entdämpft, daß eine Schwingung entsteht. Zur Erläuterung der Funktionsweise sei bei dieser einfachen Oszillatorschaltung angenommen, daß zu einem bestimmten Zeitpunkt der Transistor T1 des Differenzverstärkers sich im gesperrten Zustand befindet. Sein Basisanschluß liegt dann auf einem niedrigen elektrischen Potential. Zugleich steigt jedoch das elektrische Potential an dem Kollektoranschluß des Transistors T1 über den Wert VCC der Versorgungsgleichspannung an. Je nach Güte des Resonanzkreises bzw. allgemein der Oszillatorschaltung kann die Amplitude der am Resonanzkreis auftretenden Schwingung, d. h. das Potential am Kollektoranschluß des Transistors T1, einen sehr hohen Wert annehmen. Im selben Zeitpunkt befindet sich der Transistor T2 des Differenzverstärkers im leitenden Zustand, da einerseits das elektrische Potential an seinem Kollektoranschluß entsprechend der an den Polen des Resonanzkreises auftretenden Schwingung einen niedrigen Wert unterhalb der Versorgungsgleichspannung VCC annimmt, zugleich aber das elektrische Potential an dem Basisanschluß des Transitors T2 dem Potential am Kollektoranschluß des Transistors T1 entspricht und somit einen sehr hohen Wert annimmt. In diesem Betriebszustand ist somit das elektrische Potential an dem Basisanschluß des Transistors T2 positiver als dasjenige am Kollektoranschluß. Dadurch wechselt die Kollektor-Basis-Diode des Transistors T2 von ihrem normalerweise gesperrten Zustand in den leitenden Zustand. Der Transistor T2 geht dadurch in die Sättigung über. Durch diesen Vorgang wird die Amplitude der von der Oszillatorschaltung an den Polen des Resonanzkreises erzeugten Schwingung abrupt begrenzt; die Kuppen der sinusförmigen Schwingung werden dabei abgeschnitten. Dies führt zu einem hohen Oberwellengehalt der erzeugten Schwingung. Außerdem entstehen durch dabei auftretende Mischprozesse niederfrequente Rauschanteile, die auf die erzeugte Schwingung aufmoduliert werden und damit den Phasenrauschabstand verringern.

Dieses Betriebsverhalten kann nun erfindungsgemäß durch die kreuzweise Kopplung über die als Diode geschalteten Transistoren T3, T4 verbessert werden. Zur Erläuterung wird wiederum der Betriebsfall betrachtet, in dem der Transistor T1 gesperrt und der Transistor T2 leitend ist. Das elektrische Potential am Kollektoranschluß des Transistors T1 ist in diesem Zustand höher als das elektrische Potential am Kollektoranschluß des Transistors T2. Das Potential am Basisanschluß des Transistors T2 folgt dann aber nun nicht unmittelbar dem Potential am Kollektoranschluß des Transistors T1, sondern ist um eine Diodenflußspannung der Basis-Emitter-Diode des Transistors T4 erniedrigt. Daher werden die Transistoren T1, T2 des Differenzverstärkers bei unveränderter Amplitude der an den Polen des Resonanzkreises L, C erzeugten Schwingung nicht in dem Maße ausgesteuert wie beim Fehlen der Transistoren T3, T4. Eine Sättigung der Transistoren T1, T2 des Differenzverstärkers wird somit nur verzögert eintreten. Sie kann außerdem dadurch beeinflußt werden, daß anstelle einfacher, als Dioden geschalteter Transistoren je eine Mehrzahl solcher Transistoren in Reihe geschaltet werden.

Bei dieser Anordnung wird somit die Amplitude der von der Oszillatorschaltung erzeugten Schwingung ausschließlich durch das Nachlassen der Verstärkung und damit der Mitkopplung des Differenzverstärkers bei zunehmender differentieller Aussteuerung der Transistoren T1, T2 bestimmt. Dadurch wird ein symmetrisches, sinusförmiges Signal als erzeugte Schwingung mit sehr geringem Oberwellenanteil, d.h. sehr niedrigem Klirrfaktor, erhalten. Außerdem werden auch Mischprozesse verringert, so daß das Phasenrauschen der Oszillatorschaltung vermindert werden kann.

Ein Sättigungseffekt ist im übrigen auch von den als Dioden geschalteten Transistoren T3, T4 nicht zu erwarten, da die elektrischen Potentiale an den Kollektoranschlüssen dieser Transistoren unmittelbar den Potentialen an den Basisanschlüssen entsprechen. Somit können die Basis-Kollektor-Dioden dieser Transistoren T3, T4 nicht leitend werden.

Die in der Zeichnung symbolisch dargestellte, variable Kapazität C kann in an sich bekannter Weise als abstimmbare Kapazität mit einer Anordnung aus Festkapazitäten und Varaktordioden aufgebaut sein, mit denen die Resonanzfrequenz der Oszillatorschaltung von außen über eine Steuerspannung eingestellt werden kann. Beispielsweise enthält eine solche Anordnung eine Parallelschaltung aus einer Festkapazität mit einer Reihenschaltung aus zwei Varaktordioden, über deren Verbindungspunkt die Steuerspannung angelegt wird.

Durch die Erfindung wird somit eine sehr einfach aufgebaute Oszillatorschaltung geschaffen, die eine Erzeugung von Schwingungen mit niedrigem Klirrfaktor und niedrigem Phasenrauschen ermöglicht. Zusätzliche Schaltungen zur Vorspannung bzw. Arbeitspunkteinstellung können dabei vermieden werden, wodurch außer zusätzlichem Schaltungsaufwand auch unerwünschte zusätzliche Rauschquellen vermieden werden.

Mit modernen Fertigungsprozessen für integrierte Halbleiterschaltungen, die auch die Integration von Induktivitäten hoher Güte ermöglichen, kann die erfindungsgemäße Oszillatorschaltung vollständig auf einem Halbleiterkörper angeordnet werden, und zwar einschließlich aller Induktivitäten, Kapazitäten und Varaktordioden. In einer Abwandlung können außerdem die Induktivitäten über Gyratorschaltungen durch insbesondere kapazitive Schaltungselemente dargestellt werden, was die Auswahl der Schaltungstechniken und Fertigungsprozesse vergrößert.

Obwohl das vorstehende Ausführungsbeispiel lediglich bipolare Transistoren vom NPN-Typ umfaßt, kann eine Oszillatorschaltung nach der Erfindung in gleicher Weise auch mit bipolaren Transistoren vom PNP-Typ oder mit Feldeffekttransistoren ausgebildet sein. Anstelle der als Dioden geschalteten Transistoren T3, T4 können Schottky-Dioden treten, die dann die Diodenanordnungen bilden, über die die kreuzweise Kopplung erfolgt. Selbstverständlich umfaßt die beispielsweise Ausführung der erfindungsgemäßen Oszillatorschaltung auch eine Anordnung der Induktivität L bzw. der Teilinduktivitäen L/2 außerhalb eines Halbleiterkörpers, der die übrigen Elemente der Oszillatorschaltung umfaßt. Außerdem können diese Induktivitäten für die Erzeugung sehr hoher Frequenzen auch als Mikrostreifenleitungen bzw. vergleichbare Hochfrequenz- bzw. Mikrowellenleitungen oder -anordnungen ausgeführt sein.

## Patentansprüche

1. Oszillatorschaltung mit einem Resonanzkreis mit zwei Polen, über denen eine in der Oszillatorschaltung erzeugte Schwingung greifbar ist und mit einem Differenzverstärker aus zwei emittergekoppelten Transistoren mit zwei Kollektoranschlüssen, von denen je einer mit je einem der Pole des Resonanzkreises verbunden ist, und mit zwei Basisanschlüssen, die über Kreuz mit den Polen des Resonanzkreises gekoppelt sind, dadurch gekennzeichnet, daß die Kopplung der Basisanschlüsse mit den Polen des Resonanzkreises über je eine Diodenanordnung vorgenommen ist.

2. Oszillatorschaltung nach Anspruch 1, dadurch gekennzeichnet, daß die Diodenanordnungen je wenigstens einen Basis-Kollektor-gekoppelten Transistor umfassen.

3. Oszillatorschaltung nach Anspruch 1, dadurch gekennzeichnet, daß die Diodenanordnungen je eine Reihenschaltung aus wenigstens einem Basis-Kollektor-gekoppelten Transistor umfassen.
